# EUROPÄISCHE PATENTSCHRIFT

(11) **EP 1 616 975 B1**
(45) Veröffentlichungstag und Bekanntmachung des Hinweises auf die Patenterteilung: **08.10.2008**
(21) Anmeldenummer: 05000215.3
(22) Anmeldetag: 07.01.2005
(51) Int. Cl.: C23C 14/04, C03C 17/245, C04B 41/00, B41J 3/407

(54) **Verfahren zum Herstellen eines beschichteten Substrats**
Method for fabricating a coatet substrate
Procédé de fabrication d'un substrat revêtu

(30) Priorität: 15.07.2004 DE 102004034417
(43) Veröffentlichungstag der Anmeldung: 18.01.2006
(73) Patentinhaber: Schott AG, 55122 Mainz (DE)
(72) Erfinder: Küpper, Thomas, 37581 Bad Gandersheim (DE); Wittenberg, Dieter, 37520 Osterode (DE); Moelle, Christoph, Dr., 37581 Bad Gandersheim (DE); Zogg, Lutz, 37581 Bad Gandersheim (DE)
(74) Vertreter: Herden, Andreas F.

(56) Entgegenhaltungen:
- EP-B- 0 753 082
- DE-A1- 4 443 354
- US-A1- 2001 003 871
- US-A1- 2004 046 969

## Beschreibung

Die Erfindung betrifft das Beschichten von Substraten mit optischen Schichten, insbesondere das Beschichten gewölbter Oberflächen mit solchen Schichten.

Das Beschichten gewölbter Substrate mit optischen Schichten ist beispielsweise aus der Linsenherstellung bekannt, bei welcher Linsen mit Vergütungsschichten versehen werden. Derartige Schichten bedecken jedoch im allgemeinen die gesamte Brechfläche der Linse.

Es besteht aber andererseits Bedarf, gewölbte Oberflächen gegebenenfalls auch in ihrer flächigen Erstreckung strukturiert mit optischen Schichten zu versehen, um beispielsweise bestimmte optische Effekte zu erzielen.

Aus der DE 44 43 354 A1 ist ein Lampenkolben mit einem optischen Interferenzüberzug und ein Verfahren zu dessen Herstellung bekannt. Der Interferenzüberzug wird dabei in einem vorbestimmten Muster aufgebracht. Zur Herstellung wird auf das Substrat eine Vormaskierung und dann eine als Maske dienende Borat-Schicht aufgebracht. Auf den mit der Maske versehenen Lampenkolben wird dann eine Interferenz-Filterschicht abgeschieden und die Boratschicht danach durch Auflösen in einer wässrigen Lösung entfernt

Aus der EP 0 753 082 B1 ist es weiterhin bekannt, Kratzschutz- oder Antireflexschichten auf Brillengläsern mittels plasmaimpuls-unterstützter chemischer Dampfphasenabscheidung aufzubringen.

Die US 2001/003871 A1 beschreibt eine Vorrichtung und ein Verfahren zur Musterung konturierter Oberflächen mit komplexer Topogaphie. Dazu ist ein beweglicher Tintenstrahl-Druckkopf und ein Sensor vorgesehen, wobei mit dem Sensor die Kontur der Oberfläche erfasst wird. Sensor und Druckkopf sind über eine Steuereinheit miteinander verbunden, mit welcher der Druckkopf in festem Abstand zur Oberfläche unter Ansprechen auf die mit dem Sensor erfasste Kontur bewegt wird und die Oberfläche markiert.

Aus der US 2004/046969 A1 ist weiterhin ein Verfahren bekannt, bei welchem mit einer optischen Überwachungseinrichtung die Schichtdicke in einer Vakuumkammer während eines Vakuumabscheideprozesses bestimmt und mittels eines Rechners Korrekturdaten erzeugt werden.

Der Erfindung liegt daher die Aufgabe zugrunde, das Beschichten von Substraten mit optischen Schichten dahingehend zu verbessern, daß die Schichten eine laterale Strukturierung, beziehungsweise eine Segmentierung oder Musterung entlang der zu beschichtenden Substratoberfläche aufweisen.

Diese Aufgabe wird in höchst überraschend einfacher Weise durch ein Verfahren gemäß des unabhängigen Anspruchs 1 gelöst.

Ausgestaltungen und Weiterbildungen sind in den jeweiligen Unteransprüchen angegeben.

Demgemäß sieht die Erfindung ein Verfahren zur Herstellung eines Substrats mit einer gemusterten, beziehungsweise lateral strukturierten optischen Beschichtung auf einer gewölbten Oberfläche vor, bei welchem auf der gewölbten Oberfläche eine Maskierung aufgebracht wird, welche einen Teilbereich der gewölbten Oberfläche bedeckt, eine optische Beschichtung mit einem Vakuumabscheideverfahren aufgebracht und die Maskierung entfernt wird.

Ein erfindungsgemäßes beschichtetes Substrat, welches insbesondere mit dem erfindungsgemäßen Verfahren herstellbar ist, weist dementsprechend eine gewölbte Fläche auf, die mit einer gemusterten optischen Beschichtung derart versehen ist, daß die optische Beschichtung, insbesondere eine Vakuumbeschichtung, in zumindest einem Teilbereich dieser Fläche vorhanden ist und in zumindest einem benachbartem oder angrenzenden Teilbereich fehlt. Die optische Beschichtung wird dabei bei der Herstellung des erfindungsgemäßen Substrats auf dem oder den von der Maskierung ausgesparten Teilbereichen auf das Substrat aufgebracht und fehlt in den von der Maskierung bedeckten benachbarten Bereichen.

Eine gemusterte Beschichtung im Sinne der Erfindung ist demgemäß eine entlang ihrer flächigen Erstreckung segmentierte Beschichtung, wobei die segmentierte Beschichtung zumindest ein Segment aufweist.

Mit der Erfindung werden aufgrund der Maskierung und des Vakuumabscheidens der optischen Beschichtung gewölbte Substrate mit gemusterten optischen Beschichtungen bereitgestellt, bei welchen die Ränder oder Konturen des Musters gut definiert und scharf sind.

Hinsichtlich der Eignung eines Substrats für die Erfindung bestehen keine Beschränkungen, sofern das Substrat im Vakuum beschichtbar ist. Geeignet sind beispielsweise Glas-, Glaskeramik-, Metall- oder Kunststoffsubstrate. Insbesondere ist dabei daran gedacht, optische Komponenten als Substrate zu verwenden und diese mittels der Erfindung zu verbessern.

Für die Abscheidung sind verschiedene Vakuumabscheideverfahren geeignet. Die Wahl des Abscheideverfahrens kann dabeivon verschiedenen Auswahlkriterien abhängen, unter anderem von der Wahl des Beschichtungsmaterials oder der Geometrie der zu beschichtenden Fläche. Gemäß einer Ausführungsform des erfindungsgemäßen Verfahrens umfaßt das Aufbringen der optischen Beschichtung das Abscheiden einer Schicht mittels physikalischer Dampfphasenabscheidung (PVD). Dies kann beispielsweise das Aufdampfen oder das Aufsputtern einer Schicht umfassen. Durch Aufdampfen können hohe Abscheideraten erzielt werden und Sputtern eignet sich auch für schwer verdampfbare Materialien. Auch das Aufbringen einer Schicht mittels chemischer Dampfphasenabscheidung (CVD) ist möglich. Beispielsweise kann die Schicht mittels Plasmaimpuls-induzierter chemischer Dampfphasenabscheidung (PICVD) abgeschieden werden.

Gemäß der Erfindung umfaßt das Maskieren des Substrats das Aufbringen einer Lackschicht. Um eine in ihrer flächigen Erstreckung strukturierte Lackschicht zu erzeugen, wird die Lackschicht mittels zumindest eines rechnergesteuerten Druckkopfs aufgebracht.

Dazu geeignet ist insbesondere ein entsprechend angepaßter Druckkopf, wie er etwa in Tintenstrahldruckern eingesetzt wird. Sowohl ein Piezo-Jet-, als auch ein Bubble-Jet-Druckkopf können verwendet werden. Auf diese Weise kann direkt eine in ihrer flächigen Erstreckung strukturierte Lackschicht als Maskierung oder als Teil der Maskierung der zu beschichtenden Fläche durch Aufdrucken hergestellt werden.

Um zum Beispiel bei stark gewölbten Flächen den Abstand von Druckkopf oder Düse zur gewölbten Fläche innerhalb tolerierbarer Grenzen zu halten, wird der Abstand von Druckkopf oder Düse zur gewölbten Fläche während des Aufbringens der Lackschicht angepaßt oder nachgeführt.

Die Erfindung sieht demgemäß auch ein Verfahren zur Beschichtung von gewölbten Substraten vor, bei welchen mittels eines rechnergesteuerten Druckkopfs Lack auf die zu beschichtende Fläche aufgetragen wird, wobei mittels einer geeigneten Einrichtung der Abstand der zumindest einen Düse des Druckkopfs zur gewölbten und/oder mehrflächigen Substratoberfläche rechnergesteuert nachgeführt wird. Damit wird eine dreidimensionale Steuerung des Lackauftrag-Vorgangs erreicht.

Um insbesondere scharfe Konturen der gemusterten Lackschicht zu erzeugen und einen gleichbleibendes Druckbild zu gewährleisten, sind verschiedene Maßnahmen beim Lackauftrag von Vorteil. Beispielsweise kann der Lack gekühlt werden. Wird eine Düse, etwa als Bestandteil eines Druckkopfs für den Lackauftrag verwendet, kann es auch vorteilhaft sein, den Lack in einem mit der Düse verbundenen Vorratsbehälter oder einer Zuführleitung oder durch die Düse zu kühlen, um das Abdampfen des Lösungsmittels des Lacks vor dem Auftrag zu vermindern und damit ein Zusetzen der Druckeinrichtung zu verhindern. Eine weitere Möglichkeit, ein Zusetzen der Düse oder des Druckkopfs zu verhindern, ist das Bedrucken des Substrats in einer geeigneten Atmosphäre. Die Atmosphäre kann dazu beispielsweise komprimiert und/oder lösemittelhaltig sein, um ein Austrocknen zu verhindern.

Sobald der Lack aufgetragen ist, ist es wiederum wünschenswert, den Lack möglichst schnell zu verfestigen um ein Verlaufen auf der gewölbten Oberfläche zu verhindern und dadurch eine hohe Konturschärfe zu erreichen. Weiterhin ist es wünschenswert, enthaltenes Lösungsmittel zu entfernen, um das Ausgasen der Lackschicht in der Vakuumkammer zu reduzieren. Eine geeignete Maßnahme für diese Zwecke ist, den Lack auf ein erwärmtes Substrat aufzutragen, um das Abdampfen des Lösungsmittels zu beschleunigen.

Gemäß noch einer weiteren Ausführungsform der Erfindung kann das Maskieren des Substrats auch das Beschichten mit Photolack und das Belichten und Entwickeln des Photolacks umfassen.

Gemäß noch einer Ausführungsform des Verfahrens wird Abziehlack zur Maskierung verwendet. Dieser läßt sich nach erfolgter Beschichtung vom Substrat leicht lösen.

Eine bevorzugte Ausführungsform der Erfindung sieht vor, daß das Maskieren des Substrats das Aufbringen eines Stoplacks umfaßt, wie er etwa in der Leiterplattentechnik als Lötstoplack eingesetzt wird. Dieser Lack hat sich als besonders vakuumtauglich und thermisch stabil unter der beim Beschichten auftretenden Temperaturbelastung erwiesen.

Noch eine Ausführungsform der Erfindung sieht vor, daß das Maskieren des Substrats das Anordnen einer mechanischen Maske umfaßt. Diese ist wiederverwendbar und geeignet zur Abdeckung größerer Flächen, ohne im Vakuum auszugasen. Als Maske kann beispielsweise eine vorgeformte und entsprechend des Musters der abzuscheidenden optischen Beschichtung zugeschnittene Metall- oder Kunststofffolie verwendet werden. Als Kunststoff für eine solche Maske ist aufgrund seiner niedrigen Ausgasrate und Temperaturbeständigkeit beispielsweise Polyimid, wie etwa Kapton® geeignet.

Die verschiedenen Maskierungsverfahren können insbesondere auch vorteilhaft miteinander kombiniert werden. So sieht eine vorteilhafte Weiterbildung der Erfindung vor, daß das Maskieren des Substrats das Aufbringen einer ersten Maskierung und einer zweiten, mit der ersten Maskierung überlappenden Maskierung umfaßt. Auf diese Weise kann beispielsweise eine genau strukturierte Lackschicht-Maskierung mit scharfen, gut definierten Rändern mit einer anderen, gröberen Maskierung für größere abzudeckende Bereiche kombiniert werden. So kann eine Vormaskierung mit Abziehlack oder einer mechanischen Maske, wie etwa eine Metall- oder Polyimidfolie (z.B. eine Kapton®-Folie) zusammen mit einer Lackmaskierung mit genauen Konturen für die Ränder des abzudeckenden Bereichs eingesetzt werden.

Das Entfernen der Maskierung nach dem Abscheiden der optischen Beschichtung kann gemäß einer weiteren Ausführungsform der Erfindung das Auflösen oder Anlösen einer Lackmaskierung umfassen. Durch das Auf- oder Anlösen der Lackmaskierung wird dann auch die auf der Lackschicht befindliche abgeschiedene optische Beschichtung abgehoben, so daß eine entsprechend der Maskierung gemusterte optische Beschichtung auf den nicht von der Maskierung abgedeckten Teilbereichen der gewölbten Fläche des Substrats verbleibt.

Eine weitere Möglichkeit, um die Maskierung und die darauf befindliche optische Beschichtung zu entfernen, ist das Aufquellen der Lackmaskierung. Beispielsweise kann die Lackschicht dazu mit einer geeigneten Lauge behandelt werden. Durch das Aufquellen reißt die Lackschicht vom Substrat ab und löst sich zusammen mit der darauf vorhandenen optischen Beschichtung.

Eine erfindungsgemäß herstellbare optische Beschichtung kann auch mehrere Lagen aufweisen. Beispielsweise kann eine solche mehrlagige Schicht als optische Interferenzschicht dienen.

Eine weitere Möglichkeit einer optischen Beschichtung auf der gewölbten Fläche ist eine Beschichtung, die eine teil- oder vollreflektierende Reflexionsschicht umfaßt. Auch kann eine solche Schicht als farbig reflektierende Schicht ausgebildet sein. Zur Erzielung von Farbeffekten kann das Substrat erfindungsgemäß auch mit einer gemusterten optischen Schicht versehen werden, die eine Farb- oder Absorptionsschicht umfaßt.

Für die Anwendung der Erfindung ist eine Vielzahl von Substraten geeignet. Eine spezielle Ausführungsform der Erfindung sieht vor, daß ein Lampenkolben als Substrat dient und beschichtet wird. Mit einer erfindungsgemäßen gemusterten optischen Beschichtung auf einem Lampenkolben kann dann beispielsweise in vorteilhafter Weise das Lichtfeld des Lampenkolbens in gut definierter Weise beeinflußt werden.

Eine weitere spezielle Ausführungsform sieht vor, daß eine Linse als Substrat beschichtet wird. Auch mit einer solchen Linse mit gemusterter optischer Beschichtung kann beispielsweise das Lichtfeld einer Lampe gezielt beeinflußt werden.

Eine Weiterbildung des erfindungsgemäßen Verfahrens sieht außerdem vor, nacheinander unterschiedliche Teilbereiche der gewölbten Fläche durch Maskierung und Vakuumbeschichtung mit einer optischen Schicht zu versehen. Insbesondere ist dabei auch die Herstellung einer gemusterten optischen Beschichtung möglich, die Teilbereiche mit unterschiedlichen optischen Eigenschaften aufweist. Dazu können vorteilhaft die Teilbereiche mit unterschiedlichen optischen Beschichtungen versehen werden. Mit einem erfindungsgemäßen beschichteten Substrat, dessen gewölbte Fläche mehrere Teilbereiche mit unterschiedlichen Beschichtungen aufweist, kann so zum Beispiel eine gezielte unterschiedliche Beeinflussung des hindurchtretenden oder reflektierten Lichts in unterschiedlichen Richtungen oder Raumwinkelsegmenten oder -bereichen erreicht werden.

Um beispielsweise das Lichtfeld einer optischen Einrichtung unter Verwendung eines erfindungsgemäßen beschichteten Substrats in gewünschter Weise zu beeinflussen, kann ein ringförmiger Teilbereich der gewölbten Fläche des Substrats mit der optischen Schicht versehen sein.

Eine weitere Anwendungsmöglichkeit ist eine gemusterte Beschichtung, die eine sichtbare Information umfaßt. Diese Information kann vom Betrachter wahrgenommen werden und beispielsweise als Herkunftshinweis dienen. So kann die Beschichtung ein sichtbares Symbol oder Logo oder einen Schriftzug darstellen. Um das Lichtfeld wenig oder nicht dadurch zu beeinflussen, kann die Information enthaltende Beschichtung auch in einem für die Beleuchtung weniger relevanten Bereich als transparente oder teiltransparente Beschichtung ausgeführt werden.

Als praktische Anwendung der Erfindung ist an einen Kraftfahrzeugscheinwerfer gedacht, welcher ein erfindungsgemäß beschichtetes Substrat umfaßt. Das Substrat als Bestandteil des Scheinwerfers kann beispielsweise einen Lampenkolben und/oder eine Projektionslinse umfassen. So kann das Lichtfeld des Scheinwerfers mittels eines solchen erfindungsgemäßen Lampenkolbens oder einer erfindungsgemäß beschichteten Projektionslinse unter anderem dahingehend beeinflußt werden, daß Blendeffekte für die Fahrer entgegenkommender Fahrzeuge abgeschwächt werden.

Im folgenden wird die Erfindung anhand von Ausführungsbeispielen und unter Bezugnahme auf die Zeichnungen näher erläutert, wobei gleiche und ähnliche Elemente mit gleichen Bezugszeichen versehen sind und die Merkmale verschiedener Ausführungsbeispiele miteinander kombiniert werden können.

Es zeigen:
- Fig. 1A bis 1D: Verfahrensschritte zur Herstellung eines erfindungsgemäß beschichteten Substrats mit gewölbter Oberfläche,
- Fig. 2: eine Variante des in Fig. 1D dargestellten beschichteten Substrats,
- Fig. 3A bis 3D: Verfahrensschritte zur Herstellung eines erfindungsgemäßen beschichteten Substrats mit gewölbter Oberfläche gemäß weiterer Ausführungsformen der Erfindung,
- Fig. 4A und 4B: Verfahrensschritte zur Maskierung eines Substrats gemäß noch einer weiteren Ausführungsform der Erfindung,
- Fig. 5 bis Fig. 7: Ausführungsbeispiele von erfindungsgemäß beschichteten Substraten mit mehreren optischen Beschichtungen,
- Fig. 8 und 9: Aufsichten auf Beispiele erfindungsgemäß mit einer optischen Beschichtung versehene Linsen 101,
- Fig. 10: ein Anwendungsbeispiel für eine erfindungsgemäß beschichtete Linse,
- Fig. 11: ein Beispiel für die Beeinflussung des Lichtfelds eines Leuchtmittels mittels eines erfindungsgemäß beschichteten Lampenkolbens, und
- Fig. 12: ein weiteres Beispiel für die Beeinflussung des Lichtfelds eines Leuchtmittels mittels eines erfindungsgemäß beschichteten Lampenkolbens.

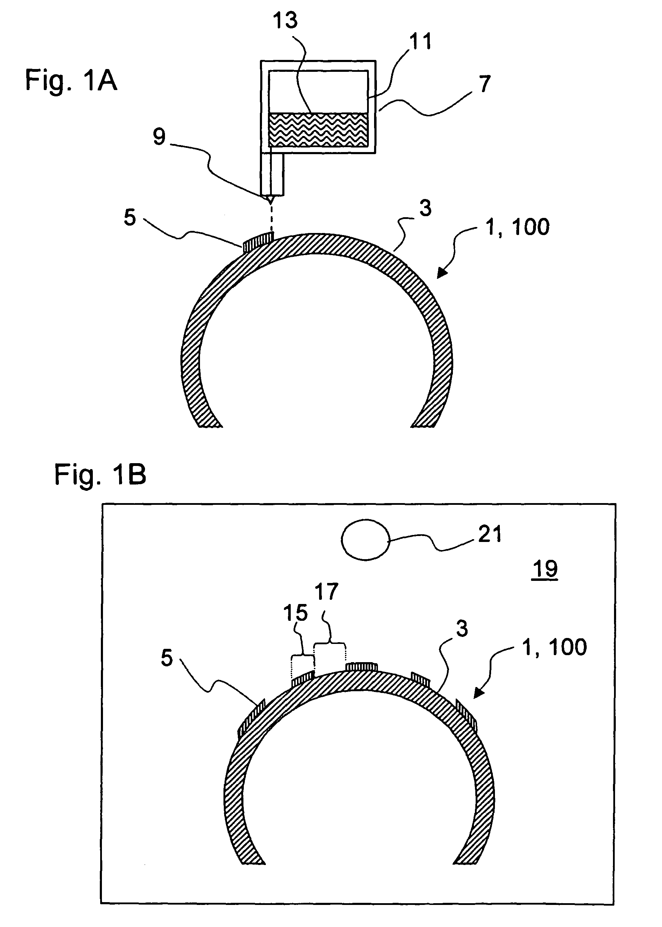

Anhand der Figuren 1A bis 1D, welche schematische Querschnittansichten eines Substrats 1 mit gewölbter Oberfläche darstellen, werden Verfahrensschritte zur Herstellung eines erfindungsgemäß beschichteten Substrats 1 gemäß einer ersten Ausführungsform der Erfindung gezeigt.

Das Verfahren zur Herstellung eines Substrats mit einer gemusterten optischen Beschichtung auf einer gewölbten Oberfläche, wie es anhand der Figuren 1A bis 1D illustriert wird, basiert darauf, daß
- auf der gewölbten Oberfläche 3 des Substrats 1 eine Maskierung aufgebracht wird, welche einen Teilbereich der gewölbten Oberfläche 3 bedeckt,
- eine optische Beschichtung mit einem Vakuumabscheideverfahren aufgebracht und
- die Maskierung entfernt wird.

Gemäß dieser ersten, in den Fig. 1A bis 1D gezeigten Ausführungsform der Erfindung wird das Substrat 1 durch das Aufbringen eines Lacks 13 maskiert, wobei das Aufbringen des Lacks 13 mittels rechnergesteuerter Düsen 9 erfolgt. Im Verfahren wird dazu der Lack 13 mittels eines Druckkopfs 7 mit Düsen 9 aufgedruckt, der an einen in Fig. 1A nicht dargestellten Rechner angeschlossen ist. Der Druckkopf, sowie eine Einrichtung zur Bewegung des Druckkopfs 7 werden vom Rechner gesteuert.

Für das Substrat kann ein beliebiges, mittels eines Vakuumabscheideverfahrens beschichtbares Material verwendet werden. Gedacht ist diesbezüglich beispielsweise an Glas, Glaskeramik, Keramik, Kunststoff und/oder Metall. Als Substrat 1 kann beispielsweise, wie in den Fig. 1A bis 1D gezeigt, ein Lampenkolben 100 verwendet werden. Auch für die erfindungsgemäße Beschichtung einer Linse als Substrat gibt es vielfältige Anwendungsmöglichkeiten.

Der Lack 13 kann beispielsweise ein Photolack, ein Abziehlack oder auch ein Stoplack, wie insbesondere ein Lötstoplack aus der Leiterplattenfertigung sein.

Als Druckkopf 7 ist insbesondere ein Tintenstrahldruckkopf geeignet. Mit einem derartigen Druckkopf kann eine gemusterte Lackschicht 5 mit besonders scharfen, gut definierten Rändern hergestellt werden.

Um den Abstand von Druckkopf 7, beziehungsweise dessen Düsen 9 zur gewölbten Fläche 3 während des Aufbringens des Lacks 13 innerhalb tolerierbarer Grenzen zur Erzeugung scharfrandiger Muster der Lackschicht 5 zu halten, wird dieser Abstand mittels einer geeigneten rechnergesteuerten Einrichtung angepaßt oder nachgeführt.

Es können zur Verbesserung des Lackauftrags auch verschiedene weitere Maßnahmen vorgenommen werden. So kann der Lack 13 im Vorratsbehälter 11 und/oder der Zuführleitung zu den Düsen 9 und/oder auch in der Düse, insbesondere mittels einer gekühlten Düse gekühlt werden, um das Abdampfen des Lösungsmittels des Lacks vor dem Auftrag zu vermindern und damit ein Zusetzen der Düse des Druckkopfs 7 zu verhindern. Das Bedrucken kann außerdem in einer geeigneten Umgebung, wie etwas einer komprimierten und/oder lösemittelhaltigen Atmosphäre erfolgen.

Um das nach dem Bedrucken im Lack der Lackschicht 5 enthaltene Lösungsmittel möglichst schnell zu entfernen und die Lackschicht zu verfestigen, sowie um zur Erzielung einer hohen Konturschärfe ein Verlaufen zu verhindern, kann das Substrat beispielsweise beim Bedrucken auch vorerwärmt sein.

Fig. 1B zeigt eine weitere Phase des Herstellungsprozesses. Die Maskierung des Substrats 1 mit der Lackschicht 5 ist abgeschlossen. Durch die Musterung der Lackschicht 5 sind Teilbereiche 15 der gewölbten Oberfläche 3 des Substrats 1 durch den Lack der Lackschicht 5 maskiert, wohingegen andere Teilbereiche 17 offen bleiben.

Das mit der gemusterten Lackschicht 5 versehene Substrat 1 wird in einer Vakuumkammer 19 gegenüber oder in einer symbolisch dargestellten Beschichtungsquelle 21 angeordnet. Mittels der Beschichtungsquelle 21 wird dann in der evakuierten Beschichtungskammer 19 eine Vakuumabscheidung einer optischen Schicht auf der mit der gemusterten Lackschicht 5 versehenen gewölbten Fläche 3 des Substrats 1 vorgenommen.

Das Vakuumabscheiden einer optischen Beschichtung kann beispielsweise das Abscheiden einer Schicht mittels physikalischer Dampfphasenabscheidung umfassen.
Die Beschichtungsquelle 21 kann gemäß einer Weiterbildung dazu eine Verdampfungseinrichtung umfassen, wobei dann das Aufbringen der optischen Beschichtung das Aufbringen einer Schicht durch Aufdampfen umfaßt. Gemäß einer anderen Weiterbildung umfaßt das Aufbringen der optischen Beschichtung das Aufsputtern einer Schicht. Demgemäß umfaßt dabei die Beschichtungsquelle 21 eine Sputterquelle.

Ebenso kann eine optische Beschichtung oder ein Bestandteil dieser Beschichtung auch durch chemische Dampfphasenabscheidung mittels einer entsprechend eingerichteten Beschichtungsquelle 21 auf der Fläche 3 abgeschieden werden. Eine bevorzugte Weiterbildung dieser Ausführungsform sieht dabei vor, daß die Schicht mittels Plasmaimpuls-induzierter chemischer Dampfphasenabscheidung (PICVD) erfolgt. Dazu umfaßt die Beschichtungsquelle 21 beispielsweise einen Gaseinlaß für geeignete Precursor-Gase, beziehungsweise gasförmigen Edukten und eine Einrichtung zur Erzeugung von gepulsten elektromagnetischen Wellen, mit welchen in der Precursor-Gasatmosphäre ein gepulstes Plasma erzeugt wird. Im Plasma entstehen Reaktionsprodukte, die sich auf der Fläche 3 anlagern und eventuell miteinander reagieren, so daß eine Schicht auf der Fläche 3 abgeschieden wird.

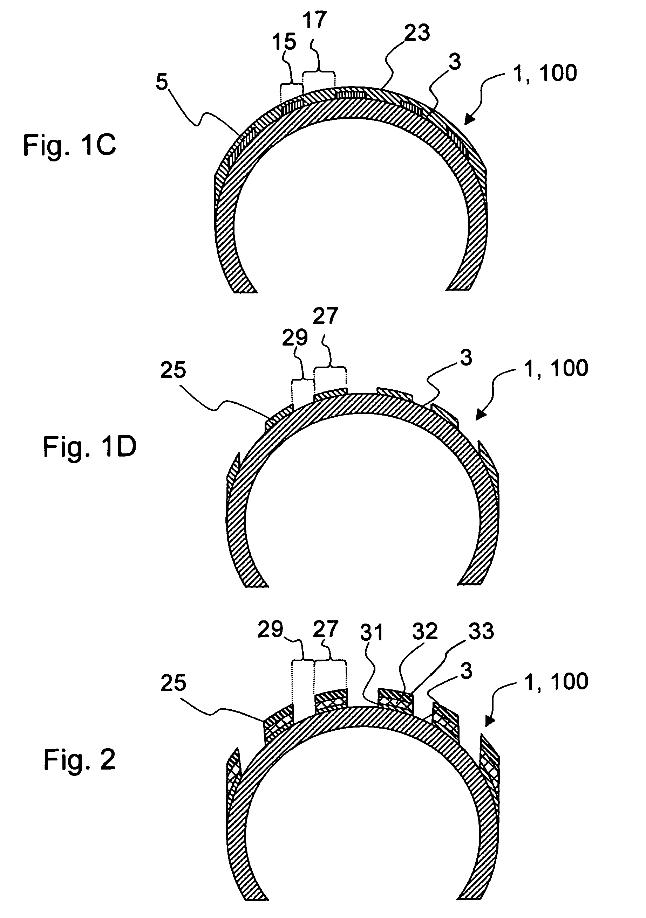

Das mit der mittels Vakuumabscheidung beschichtete Substrat 1 ist in Fig. 1C dargestellt. Das Substrat weist entsprechend der bisherigen Verfahrensschritte nun eine Maskierung in Form einer gemusterten Lackschicht 5 auf der gewölbten Fläche 3 auf, durch welche Teilbereiche 15 der Fläche 3 maskiert und andere Teilbereiche 17 offen sind. Über der Fläche 3 samt Maskierung ist eine optische Beschichtung 23 mittels Vakuumabscheidung aufgebracht. Diese Beschichtung ist in den von der gemusterten Lackschicht 5 offen gelassenen Teilbereichen 17 in Kontakt mit dem Substrat 14, beziehungsweise dessen Fläche 3. Als nächster Schritt wird nun die Maskierung entfernt. Dazu kann die Lackschicht beispielsweise mittels eines geeigneten Lösungsmittels angelöst oder aufgelöst werden. Eine weitere Möglichkeit besteht darin, die Lackschicht aufquellen zu lassen. Beispielsweise kann dazu eine Lauge, wie etwa Kali- oder Natronlauge verwendet werden. Das Entfernen der Lackschicht durch Aufquellen eignet sich insbesondere bei der Verwendung von Stoplack, der überdies eine gute Temperaturbeständigkeit und geringe Ausgasrate im Vakuum aufweist.

In beiden Fällen löst sich die gemusterte Lackschicht 5 von der gewölbten Fläche 3, so daß auch die auf der Lackschicht 5 in den Bereichen 15 befindliche optische Beschichtung 23 entfernt wird und nur die optische Beschichtung 23 in den von der gemusterten Lackschicht 5 freigelassenen Teilbereichen 17 auf der Fläche 3 verbleibt.

Ein Ausführungsbeispiel eines erfindungsgemäß beschichteten Substrats als Erzeugnis dieser Ausführungsform des Verfahrens ist in Fig. 1D dargestellt. Dieses beschichtete Substrat 1 weist dementsprechend eine gewölbte Fläche 3 auf, die mit einer gemusterten optischen Beschichtung 25 derart versehen ist, daß die optische Beschichtung 25 in zumindest einem Teilbereich 27 dieser Fläche 3 vorhanden ist und in zumindest einem benachbartem Teilbereich 29 fehlt.

Die gemusterte optische Beschichtung 25 wurde dabei wie vorstehend beschrieben durch Entfernen der Lackschicht 5 zusammen mit der optischen Beschichtung 23 auf den maskierten Bereichen 15 erzeugt. Die von der gemusterten optischen Beschichtung 25 bedeckten Teilbereiche 27 entsprechen dementsprechend den von der gemusterten Lackschicht 5 offen gelassenen Bereichen der gewölbten Fläche 3, während die benachbarten Teilbereiche 29, auf welchen die optische Beschichtung 25 fehlt, den von der gemusterten Lackschicht 5 vormals bedeckten Bereichen 15 entsprechen.

Fig. 2 zeigt ein weiteres Ausführungsbeispiel eines erfindungsgemäß beschichteten Substrats 1, welches mit einer Variante des anhand der Fig. 1A bis 1D dargestellten Verfahrensschritte erhalten werden kann.

Im Unterschied zu dem in Fig. 1D gezeigten Ausführungsbeispiel weist das in Fig. 2 dargestellte beschichtete Substrat 1 eine mehrlagige gemusterte optische Beschichtung 25 mit Lagen 31, 32, 33 auf. Eine solche mehrlagige optische Beschichtung 25 kann aufgebracht werden, indem mit einer geeigneten Beschichtungsquelle 21 in der in Fig. 1B gezeigten Vakuum- oder Beschichtungskammer 19 sequentiell mehrere Lagen 31, 32, 33 abgeschieden werden. Beispielsweise kann mittels einer als PICVD-Einrichtung ausgebildeten Beschichtungsquelle 21 eine mehrlagige gemusterte optische Beschichtung 25 aufgebracht werden, indem für jede Schicht die Zusammensetzung der Gasatmosphäre verändert wird.

Selbstverständlich ist die Anzahl der in Fig. 2 dargestellten Lagen der Beschichtung 25 lediglich beispielhaft. Wird etwa eine Interferenzfilter-Schicht abgeschieden, können auch mehr als drei Lagen 31, 32, 33 vorhanden sein. Eine wie in Fig. 2 dargestellte dreilagige Schicht ist, um nur ein Beispiel zu nennen, als gemusterte Vergütung geeignet.

Allgemein kann eine gemusterte optische Beschichtung 25, wie sie in den Fig. 1D oder 2 dargestellt ist, je nach Einsatzzweck beispielsweise eine teil- oder vollreflektierende Reflexionsschicht, eine farbig reflektierende optische Schicht, eine Interferenzschicht und/oder auch eine Farb- oder Absorbtionsschicht umfassen.

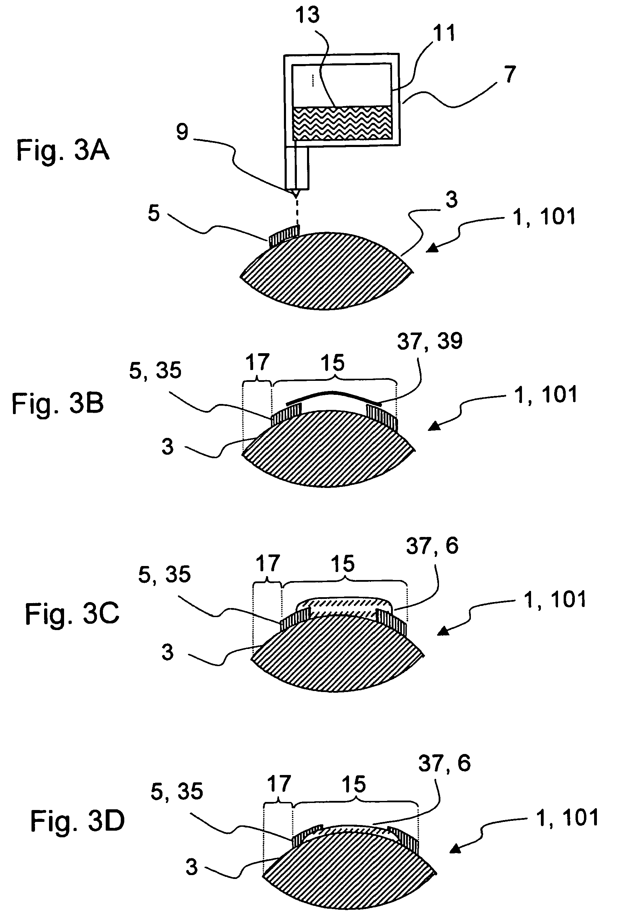

Die Fig. 3A bis 3D zeigen Verfahrensschritte zur Herstellung eines erfindungsgemäß beschichteten Substrats mit gewölbter Oberfläche gemäß verschiedener Varianten einer weiteren Ausführungsform der Erfindung. Gemäß dieser Ausführungsform des Verfahrens, wie es anhand der Fig. 3A bis 3D dargestellt wird, umfaßt dabei das Maskieren des Substrats 1 das Aufbringen einer ersten Maskierung 35 und einer zweiten, mit der ersten Maskierung überlappenden Maskierung 37.

Fig. 3A zeigt zunächst das Maskieren des Substrats 1 durch Aufdrucken einer Lackschicht 5 mittels rechnergesteuerter Düsen 9 eines Druckkopfs 7, wie es in ähnlicher Weise auch anhand von Fig. 1A dargestellt ist. Bei dem in Fig. 3A gezeigten Ausführungsbeispiel wird dabei eine optische Linse 101 als Substrat 1 verwendet.

Im Unterschied zu der anhand der Fig. 1A bis 1D gezeigten Ausführungsform wird nur ein konturnaher Bereich der zu maskierenden Teilbereiche 15 bedruckt, um eine erste Maskierung 35 zu erzeugen, die zur Herstellung scharfer Konturen des Musters der später aufzubringenden optischen Beschichtung dient. Die übrige Fläche des oder der Teilbereiche 15 wird mit einer zweiten, mit der Lackschicht 5, beziehungsweise der ersten Maskierung 35 überlappenden Maskierung 37 versehen. Die Figuren 3B bis 3D zeigen Beispiele solcher überlappender erster und zweiter Maskierungen 35, 37.

Bei dem in Fig. 3B gezeigten Beispiel umfaßt das Maskieren des Substrats das Anordnen einer vorgeformten mechanischen Maske 39, die in diesem Beispiel als zweite Maskierung für den Teilbereich 15 der gewölbten Fläche 3 dient. Beispielsweise kann die Maske 39 eine Konturmaske aus einer Kunststoff- oder Metallfolie oder eine andersartige Schablone sein. Die Verwendung einer solchen Maske ist beispielsweise von Vorteil, wenn ein übermäßiges Ausgasen der Lackschicht 5 im Vakuum vermieden werden soll. Durch die Verwendung einer weiteren Maske -wie hier einer mechanischen Maskierung- kann die aufgetragene Lackmenge deutlich verringert werden.

Eine weitere Möglichkeit zeigen die Figuren 3C und 3D. Auch bei diesen Beispielen dient eine Lackschicht 5 als erste Maskierung 35. Als zweite, mit der ersten Maskierung 35 überlappende zweite Maskierung dient eine zweite Lackschicht 6. Bei dem in Fig. 3C gezeigten Beispiel wird die zweite Lackschicht 6, welche den innen liegenden Teil der Maskierung des Teilbereichs 15 bildet, nach dem Aufbringen der Lackschicht 5 aufgetragen. Die Lackschicht 5 bildet hierbei die Kontur des oder der Teilbereiche 15.

Ebenso läßt sich aber auch, wie anhand von Fig. 3D gezeigt ist, erst der innen liegende Teil des Bereichs 15 mit einer Maskierung 37 aus einer Lackschicht 6 und danach der konturbildende Randbereich mit einer weiteren, mit der Maskierung 37 überlappenden Maskierung 35 versehen. Für die Maskierungen 35, 37, beziehungsweise die Lackschichten 5, 6 können sowohl gleichartige, als auch verschiedene Lacke verwendet werden. Beispielsweise kann für die äußere Maskierung 35 ein Stoplack verwendet werden, der besonders gut und genau aufgetragen werden kann und vergleichsweise temperaturbeständig ist. Als innere Maskierung 37 kann dann ein Abziehlack verwendet werden, der leicht von der gewölbten Fläche 3 abziehbar ist.

Das gemäß den Fig. 3A bis 3D maskierte Substrat 1 kann dann wie anhand der Fig. 1B bis 1D dargestellt, beschichtet und die Maskierung samt darauf abgeschiedener optischer Beschichtung entfernt werden, um ein beschichtetes Substrat 1, wie in Fig. 1D oder 2 gezeigt, zu erhalten. Dabei kann die Maske 39 des in Fig. 3B gezeigten Beispiels auch alternativ erst dann vor der Fläche 3 angeordnet werden, wenn das Substrat in der Vakuumkammer 19 positioniert ist.

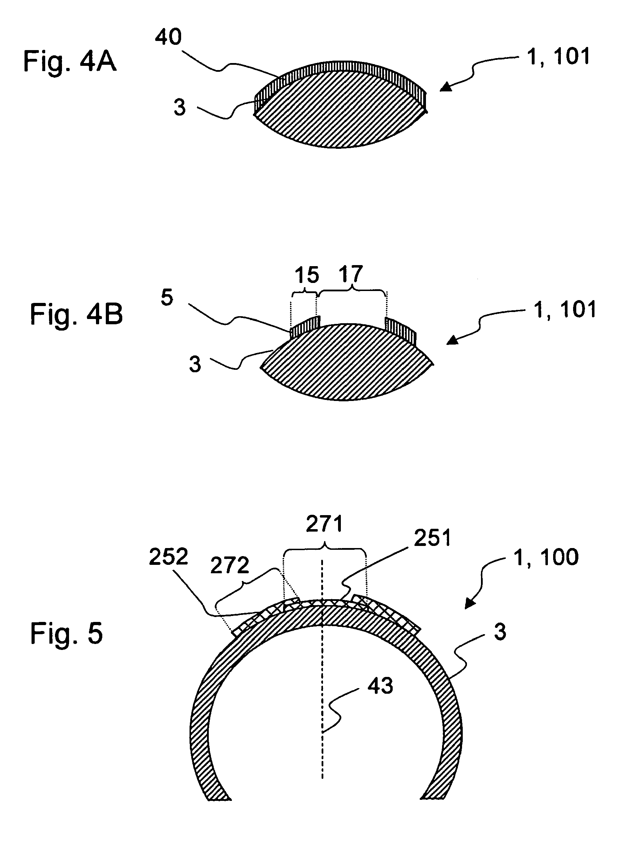

Noch ein weiteres Ausführungsbeispiel zur Maskierung der Fläche 3 zeigen die Fig. 4A und 4B. Auch hier ist eine optische Linse 101 als Substrat 1 für die Beschichtung mit einer gemusterten optischen Schicht vorgesehen. Die Maskierung erfolgt bei diesem Beispiel durch Beschichten mit Photolack und anschließendem Belichten und Entwickeln des Photolacks. Das Beschichten erfolgt bei dem dargestellten Ausführungsbeispiel durch einen flächigen Auftrag des Photolacks 40. Der Auftrag kann beispielsweise in üblicher Weise durch Aufwalzen geschehen. Anschließend wird der Photolack 40 entsprechend der gewünschten Musterung der Maskierung belichtet und entwickelt, so daß eine wie in Fig. 4B schematisch dargestellte gemusterte Lackschicht 5 als Maskierung der gewölbten Fläche 3 des Substrats 1 erhalten wird.

Anschließend kann das so maskierte Substrat wie anhand der Fig. 1B bis 1D erläutert weiterbehandelt werden, um ein erfindungsgemäß beschichtetes Substrat mit gemusterter optischer Beschichtung zu erhalten.

Die oben beschriebenen Ausführungsbeispiele zeigen eine einzelne optische Beschichtung. Mit dem erfindungsgemäßen Verfahren ist es selbstverständlich aber auch möglich, mehrere verschiedene oder gleichartige optische Beschichtungen aufzutragen, die insbesondere auch alle gemustert sein können. Solche Ausführungsbeispiele sind in den Figuren 5 bis 7 dargestellt.

In Fig. 5 ist ein Ausführungsbeispiel eines Lampenkolbens 100 als Substrat 1 dargestellt, auf dessen gewölbter Außenfläche nacheinander zwei optische Beschichtungen 251, 252 unter Verwendung des erfindungsgemäßen Verfahrens, wie beispielsweise anhand der Figuren 1A bis 1D beschrieben aufgebracht wurden. Die Schichten 251, 252 bedecken jeweils Teilbereiche 271, beziehungsweise 272 der gewölbten Fläche 3, wobei die jeweilige Beschichtung 251, 252 in den zu den Teilbereichen 271, beziehungsweise 272 angrenzenden Bereichen fehlt. Die beiden gemusterten optischen Schichten 251, 252 überlappen außerdem bei dem in Fig. 5 gezeigten Ausführungsbeispiel. Weiterhin können die beiden Schichten 251 und 252 bei dem in Fig. 5 gezeigten Beispiel hinsichtlich ihres Schichtmaterials auch gleichartig sein.

Die Schichten 251, 252 können sich aber zum Beispiel in ihrer Dicke unterscheiden, so daß die Schichten unterschiedliche optische Effekte bewirken.

Bei diesem Ausführungsbeispiel wurde zuerst die gemusterte optische Schicht 251 aufgebracht, die einen kreisförmigen Bereich um die Symmetrieachse 43 des Lampenkolbens 100, beziehungsweise des Substrats bedeckt und dementsprechend als runder Fleck gemustert ist. Anschließend wurde die zweite Beschichtung 251 aufgebracht, die so gemustert ist, daß ein ringförmiger Teilbereich 272 der gewölbten Fläche 3 mit der optischen Beschichtung versehen, beziehungsweise von dieser bedeckt ist. Dieses ringförmige Muster der optischen Beschichtung 252 überlappt bei dem in Fig. 5 gezeigten Ausführungsbeispiel mit dem Rand der kreisförmig gemusterten Schicht 251.

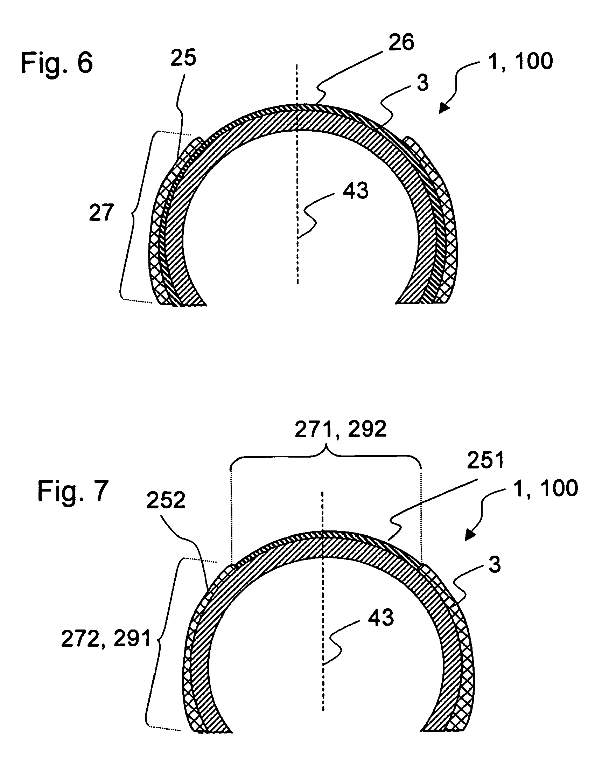

Fig. 6 zeigt in Querschnittansicht durch das Substrat 1 ein weiteres Ausführungsbeispiel mit mehreren optischen Beschichtungen. Bei diesem Ausführungsbeispiel ist eine erste optische Beschichtung 26 auf dem Substrat 1 aufgebracht, die nicht gemustert ist und die gesamte gewölbte Fläche 3 bedeckt. Darauf befindet sich eine erfindungsgemäß aufgebrachte gemusterte optische Beschichtung 25, die ähnlich wie die in Fig. 5 gezeigte optische Beschichtung 252 dergestalt gemustert ist, daß sie einen ringförmigen Bereich 27 um die Symmetrieachse des Substrats bedeckt und ein runder Bereich um die Symmetrieachse 43 frei bleibt, beziehungsweise nicht von der Schicht 25 bedeckt ist.

Bei dem in Fig. 7 gezeigten Ausführungsbeispiel sind zwei gemusterte optische Beschichtungen 251, 252 mit unterschiedlichen optischen Eigenschaften auf der Fläche 3 abgeschieden worden. Diese Beschichtungen bedecken jeweils unterschiedliche, nicht überlappende Teilbereiche 271, 272, ohne daß zwischen den Schichten 251, 252 ein Spalt vorhanden ist. Die Schichten 251, 252 können beispielsweise unterschiedlich reflektierend oder absorbierend sein.

Mit dem erfindungsgemäßen Verfahren können die Schichten 251, 252 gut definiert mit scharfen Konturen abgeschieden werden. Die Musterung der Schichten kann damit beispielsweise so genau plaziert werden, daß die beiden Schichten 251, 252 wie in diesem Beispiel ohne Zwischenraum oder ohne einen wesentlichen Spalt aneinander angrenzen. Damit entsprechen der oder die von der einen gemusterten optischen Beschichtung 251 bzw. 252 bedeckten Teilbereiche 271, 272 den von jeweils anderen gemusterten optischen Beschichtung 251, 252 frei gelassenen Teilbereichen 292, beziehungsweise 291.

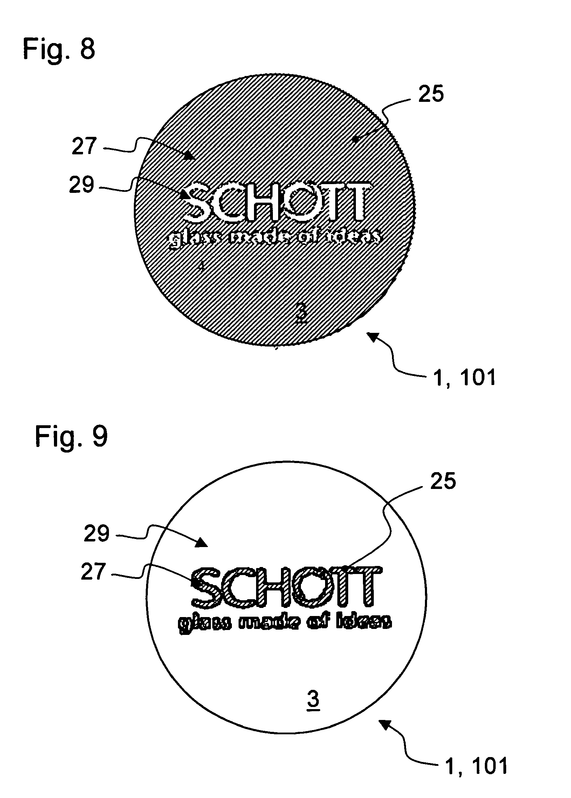

Die Fig. 8 und 9 zeigen Aufsichten auf weitere Beispiele erfindungsgemäß mit einer optischen Beschichtung versehene Linsen 101 als Substrate 1. Bei diesen Ausführungsbeispielen umfaßt die gemusterte optische Beschichtung, jeweils eine sichtbare Information. Als sichtbare Information ist in den Fig. 8 und 9 ein Schriftzug dargestellt, die Information kann aber auch ein Logo oder ein Symbol umfassen.

Bei dem in Fig. 8 gezeigten Ausführungsbeispiel wird der Schriftzug auf der gewölbten Seite 3 der Linse 101 durch die unbeschichteten Teilbereiche 29 der gewölbten Fläche 3 gebildet, in denen die in Form des Schriftzug gemusterte optischen Beschichtung 25 fehlt. Ebenso ist aber auch eine gemusterte Beschichtung 25 möglich, wie sie in Fig. 9 dargestellt ist. Bei diesem Ausführungsbeispiel wird der Schriftzug durch die beschichteten Teilbereiche 27 der entsprechend dem Schriftzug gemusterten optischen Beschichtung gebildet.

Die erfindungsgemäß hergestellte, mit einem Logo oder Schriftzug gemusterte optische Beschichtung 25 auf den Linsen 101 der Fig. 8 und 9 kann insbesondere eine teil- oder vollreflektierende Reflexionsschicht, eine farbig reflektierende optische Beschichtung, eine Interferenzschicht, und/oder eine Farb- oder Absorptionsschicht umfassen.

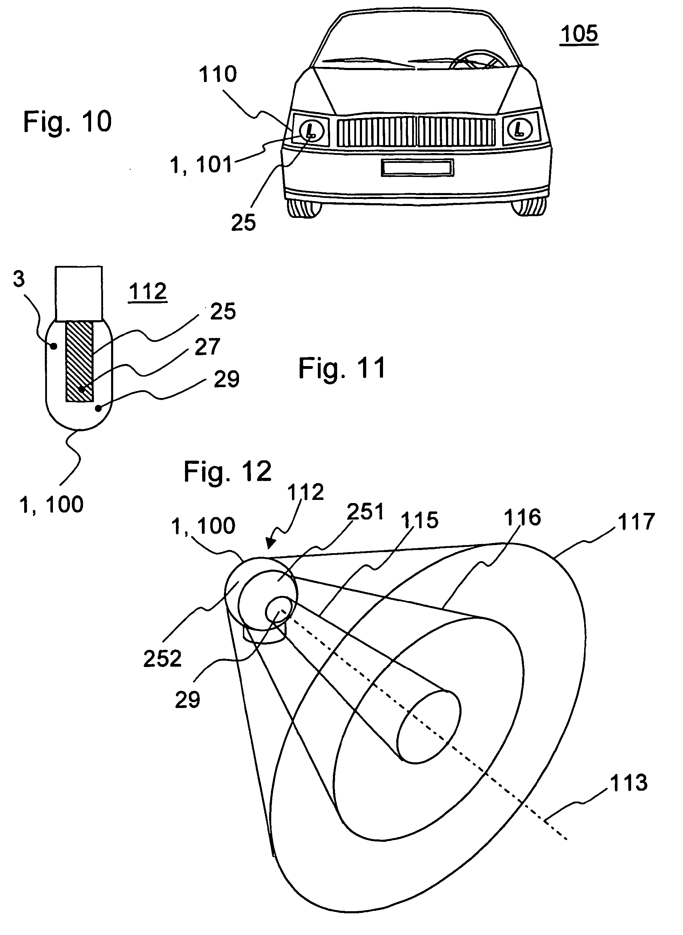

Fig. 10 zeigt ein Anwendungsbeispiel für erfindungsgemäß beschichtete Linsen, wie sie beispielsweise in den Fig. 8 oder 9 dargestellt sind. Fig. 10 zeigt die Frontansicht eines Kraftfahrzeugs 105 mit Scheinwerfern 110. Die Scheinwerfer 110 des Kraftfahrzeugs 105 weisen jeweils erfindungsgemäß beschichtete Substrate 1 in Form von beschichteten Projektionslinsen 101 auf. Die optische Beschichtung 25 kann dabei auf einer oder beiden Brechflächen der Linsen 101 vorhanden sein. Die optischen Beschichtungen 25 auf den Projektionslinsen 101 sind insbesondere in Form einer sichtbaren Information ähnlich den in Fig. 8 oder 9 gezeigten Ausführungsbeispielen gemustert. Insbesondere kann bei diesem Ausführungsbeispiel die Beschichtung in Form eines Logos gemustert sein, wobei das durch die Beschichtung 25 gebildete Logo in Fig. 10 lediglich beispielhaft in Form eines kursiven "L" symbolisiert ist. Beispielsweise können die gemusterten Beschichtungen 25 in Form des Logos oder Schriftzugs des Herstellers des Kraftfahrzeugs gemustert sein. Dieses Logo ist dann bei ausgeschaltetem Scheinwerfer oder bei leichter Beleuchtung, etwa bei Einschaltung des Standlichts sichtbar und ergibt einen reizvollen dekorativen Effekt.

Zusätzlich oder alternativ können auch Leuchtmittel mit erfindungsgemäß beschichteten Lampenkolben, wie sie etwa in den Fig. 1D, 2, 5 bis 7 schematisch dargestellt sind, verwendet werden. Ein Ausführungsbeispiel für ein Leuchtmittel mit vorteilhaften Beleuchtungseigenschaften, insbesondere auch für den Automobilbereich zeigt Fig. 11.

Das Leuchtmittel in Form einer Lampe 112 umfaßt einen Lampenkolben 100. Der Lampenkolben 100 weist beispielhaft eine langgestreckte zylindrische Form mit abgerundeten Enden auf. Die gewölbte Außenseite des Lampenkolbens 100 ist mit einer optischen Beschichtung 25 versehen, die dergestalt gemustert ist, daß sie einen Teilbereich 27 der gewölbten Oberfläche 3 des Lampenkolbens 100 bedeckt, wobei benachbarte Teilbereiche 29 frei bleiben. Die optische Beschichtung 25 kann beispielsweise eine mehrlagige Interferenz-Filterschicht umfassen, welche eine Farbtönung des emittierten Lichts bewirkt. Aufgrund dieses Musters der Beschichtung wird damit in einem Sektor oder Raumwinkelbereich des vom Leuchtmittel erzeugten Lichtfelds eine Farb- und Abtönwirkung erreicht, beispielsweise um Blendeffekte zu reduzieren.

Fig. 12 zeigt ein weiteres Beispiel für ein Leuchtmittel mit beschichtetem Lampenkolben, wie er vorteilhaft beispielsweise für Kraftfahrzeugscheinwerfer verwendet werden kann. Das Leuchtmittel in Form einer Lampe 112 umfaßt einen Lampenkolben 100. Dessen gewölbte Außenseite ist mit optischen Beschichtungen 251, 252 versehen, die ringförmige Bereiche um eine Achse 113 bedecken, wobei bei diesem Beispiel ein kreisförmiger Bereich 29 um die Achse 113 frei bleibt, beziehungsweise von den ringförmig gemusterten optischen Beschichtungen nicht bedeckt wird.

Die optischen Schichten 251, 252 können beispielsweise jeweils eine Interferenzschicht mit mehreren Lagen, wie sie etwa schematisch in Fig. 2 gezeigt ist, umfassen. Mit den optischen Schichten kann dann eine Farb- und/oder Helligkeitsfilterung des aus dem Lampenkolben 100 emittierten Lichts vorgenommen werden.

Aufgrund der Musterung der optischen Schichten 251, 252 wird das vom Leuchtmittel erzeugte Lichtfeld beeinflußt. Die in Fig. 11 beispielhaft gezeigte Anordnung führt bei unterschiedlich farbfilternden oder abtönenden optischen Schichten 251, 252 beispielsweise zu unterschiedlich gefärbten und/oder hellen Raumwinkelbereichen 115, 116, 117 um die Achse 113. Diesen Effekt kann man sich beispielsweise für die Beeinflussung des Lichtfelds eines Kraftfahrzeugscheinwerfers zunutze machen, etwa, um Blendeffekte zu vermeiden.

Die Form der Musterung der in Fig. 11 und 12 gezeigten Ausführungsbeispiels ist selbstverständlich rein beispielhaft. Die optischen Schichten 251, 252 können beispielsweise auch asymmetrisch ringförmig sein oder beliebige andere Formen von Teilbereichen der gewölbten Außenfläche des Lampenkolbens bedecken. Die Form der optischen Schichten und die Anzahl der verschiedenen Schichten kann dabei insbesondere an die gewünschte Form des Lichtfelds angepaßt werden.

Es ist dem Fachmann ersichtlich, dass die Erfindung nicht auf die vorstehend beschriebenen beispielhaften Ausführungsformen beschränkt ist, sondern vielmehr in vielfältiger Weise variiert werden kann. Insbesondere können die Merkmale der einzelnen Ausführungsbeispiele auch miteinander kombiniert werden.

### Bezugszeichenliste

- 1: Substrat mit gewölbter Oberfläche
- 3: gewölbte Oberfläche von 1
- 5, 6: Lackschicht
- 7: Druckkopf
- 9: Düse von 7
- 11: Tank von 7
- 13: Lack
- 15: maskierter Teilbereich von 3
- 17: offener, nicht maskierter Teilbereich von 3
- 19: Vakuum- oder Beschichtungskammer
- 21: Beschichtungsquelle
- 23: optische Beschichtung
- 25, 251, 252,: gemusterte optische Beschichtung
- 26: optische Beschichtung
- 27, 271, 272: von 25 bedeckter Teilbereich von 3
- 29, 291, 292: zu 27 benachbarter, unbeschichteter Teilbereich von 3
- 31, 32, 33: Lagen von 25
- 35, 37: einander überlappende Maskierungen
- 39: mechanische Maske
- 40: Photolack
- 43: Symmetrieachse
- 100: Lampenkolben
- 101: Linse
- 105: Kraftfahrzeug
- 110: Scheinwerfer
- 112: Lampe
- 113: Achse
- 115,116, 117: Raumwinkelbereich

## Patentansprüche

1. Verfahren zur Herstellung eines Substrats (1) mit einer gemusterten optischen Beschichtung auf einer gewölbten Oberfläche (3), bei welchem
- auf der gewölbten Oberfläche (3) eine Maskierung aufgebracht wird, welche einen Teilbereich der gewölbten Oberfläche (3) bedeckt,
- eine optische Beschichtung (23) mit einem Vakuumabscheideverfahren aufgebracht und
- die Maskierung entfernt wird, **dadurch gekennzeichnet, daß** als Maskierung eine Lackschicht (5) mittels eines rechnergesteuerten Druckkopfs aufgedruckt wird wobei der Abstand des Druckkopfs zur gewölbten Fläche während des Aufbringens der Lackschicht (5) angepaßt oder nachgeführt wird.

2. Verfahren gemäß Anspruch 1, **dadurch gekennzeichnet, daß** das Aufbringen der optischen Beschichtung (23) das Abscheiden einer Schicht mittels physikalischer Dampfphasenabscheidung (PVD) umfaßt.

3. Verfahren gemäß Anspruch 1 oder 2, **dadurch gekennzeichnet, daß** das Aufbringen der optischen Beschichtung (23) das Aufbringen einer Schicht durch Aufdampfen umfaßt.

4. Verfahren gemäß einem der vorstehenden Ansprüche, **dadurch gekennzeichnet, daß** das Aufbringen der optischen Beschichtung (23) das Aufsputtern einer Schicht umfaßt.

5. Verfahren gemäß einem der vorstehenden Ansprüche, **dadurch gekennzeichnet, daß** das Aufbringen der optischen Beschichtung (23) das Aufbringen einer Schicht mittels chemischer Dampfphasenabscheidung (CVD) umfaßt.

6. Verfahren gemäß Anspruch 5, **dadurch gekennzeichnet, daß** die Beschichtung mittels Plasmaimpuls-induzierter chemischer Dampfphasenabscheidung (PICVD) erfolgt.

7. Verfahren gemäß einem der vorstehenden Ansprüche, **dadurch gekennzeichnet, daß** der Lack (13) gekühlt wird.

8. Verfahren gemäß Anspruch 7, **dadurch gekennzeichnet, daß** der Lack (13) in einem mit der Düse (9) verbundenen Vorratsbehälter (11) oder durch die Zuführleitung oder durch die Düse (9) gekühlt wird.

9. Verfahren gemäß einem der vorstehenden Ansprüche,
**dadurch gekennzeichnet, daß** der Lack (13) in einer lösemittelhaltigen oder komprimierten Atmosphäre aufgebracht wird.

10. Verfahren gemäß einem der vorstehenden Ansprüche, **dadurch gekennzeichnet, daß** der Lack (13) auf ein erwärmtes Substrat (1) aufgebracht wird.

11. Verfahren gemäß einem der vorstehenden Ansprüche, **dadurch gekennzeichnet, daß** das Maskieren des Substrats (1) das Aufbringen eines Abziehlacks umfaßt.

12. Verfahren gemäß einem der vorstehenden Ansprüche, **dadurch gekennzeichnet, daß** das Maskieren des Substrats (1) das Anordnen einer mechanischen Maske (39) umfaßt.

13. Verfahren gemäß einem der vorstehenden Ansprüche, **dadurch gekennzeichnet, daß** das Maskieren des Substrats das Aufbringen einer ersten Maskierung (5) und einer zweiten, mit der ersten Maskierung überlappenden Maskierung (6) umfaßt.

14. Verfahren gemäß einem der vorstehenden Ansprüche, **dadurch gekennzeichnet, daß** das Entfernen der Maskierung das Auflösen oder Anlösen einer Lackmaskierung (5) umfaßt.

15. Verfahren gemäß einem der vorstehenden Ansprüche, **dadurch gekennzeichnet, daß** eine mehrlagige optische Beschichtung (23) aufgebracht wird.

16. Verfahren gemäß einem der vorstehenden Ansprüche, **dadurch gekennzeichnet, daß** das Substrat (1) mit einer optischen Schicht beschichtet wird, die eine teil- oder vollreflektierende Reflexionsschicht umfaßt.

17. Verfahren gemäß Anspruch 16, **dadurch gekennzeichnet, daß** eine farbig reflektierende optische Beschichtung aufgebracht wird.

18. Verfahren gemäß einem der vorstehenden Ansprüche, **dadurch gekennzeichnet, daß** das Substrat (1) mit einer optischen Beschichtung (23) beschichtet wird, die eine Interferenzschicht umfaßt.

19. Verfahren gemäß einem der vorstehenden Ansprüche, **dadurch gekennzeichnet, daß** das Substrat (1) mit einer optischen Beschichtung (23) beschichtet wird, die eine Farb- oder Absorbtionsschicht umfaßt.

20. Verfahren gemäß einem der vorstehenden Ansprüche, **dadurch gekennzeichnet, daß** ein Lampenkolben (100) beschichtet wird.

21. Verwendung einer Vorrichtung zur Beschichtung von gewölbten und/oder mehrflächigen Substraten (1) für das Verfahren gemäß einem der vorstehenden Ansprüche, wobei die Vorrichtung, einen rechnergesteuerten Druckkopf (7) mit einem mit Lack (13) gefüllten Vorratsbehälter (11) -zur Beschichtung einer Fläche (3) eines gewölbten und/oder mehrflächigen Substrats (1) mit Lack (13), sowie eine Einrichtung zum rechnergesteuerten Nachführen des Abstands der zumindest einen Düse (9) des Druckkopfs (7) zur gewölbten und/oder mehrflächigen Substratoberfläche (3) umfasst.

## Claims

1. Method for producing a substrate (1) having a patterned optical coating on a curved surface (3), in which
- a mask is applied to the curved surface (3) and covers a partial region of the curved surface (3),
- an optical coating (23) is applied by a vacuum deposition process and
- the mask is removed, **characterised in that** a lacquer layer (5) is printed on as the mask using a computer-controlled print head, wherein the distance from the print head to the curved surface is adapted or tracked during the application of the lacquer layer (5).

2. Method as claimed in claim 1, **characterised in that** the application of the optical coating (23) comprises the deposition of a layer by means of physical vapour deposition (PVD).

3. Method as claimed in claim 1 or 2, **characterised in that** the application of the optical coating (23) comprises the application of a layer by vapour deposition.

4. Method as claimed in any one of the preceding claims, **characterised in that** the application of the optical coating (23) comprises the sputtering of a layer.

5. Method as claimed in any one of the preceding claims, **characterised in that** the application of the optical coating (23) comprises the application of a layer by means of chemical vapour deposition (CVD).

6. Method as claimed in claim 5, **characterised in that** the coating is effected by means of plasma pulse-induced chemical vapour deposition (PICVD).

7. Method as claimed in any one of the preceding claims, **characterised in that** the lacquer (13) is cooled.

8. Method as claimed in claim 7, **characterised in that** the lacquer (13) is cooled in a storage container (11) connected to the nozzle (9) or is cooled via the supply line or via the nozzle (9).

9. Method as claimed in any one of the preceding claims, **characterised in that** the lacquer (13) is applied in a solvent-containing or compressed atmosphere.

10. Method as claimed in any one of the preceding claims, **characterised in that** the lacquer (13) is applied to a heated substrate (1).

11. Method as claimed in any one of the preceding claims, **characterised in that** the masking of the substrate (1) comprises the application of a pull-off lacquer.

12. Method as claimed in any one of the preceding claims, **characterised in that** the masking of the substrate (1) comprises the placement of a mechanical mask (39).

13. Method as claimed in any one of the preceding claims, **characterised in that** the masking of the substrate comprises the application of a first mask (5) and of a second mask (6) overlapping with the first mask.

14. Method as claimed in any one of the preceding claims, **characterised in that** the removal of the mask comprises the dissolving or etching of a lacquer mask (5).

15. Method as claimed in any one of the preceding claims, **characterised in that** a multi-layer optical coating (23) is applied.

16. Method as claimed in any one of the preceding claims, **characterised in that** the substrate (1) is coated with an optical layer which comprises a partially or fully reflective reflection layer.

17. Method as claimed in claim 16, **characterised in that** a colour-reflecting optical coating is applied.

18. Method as claimed in any one of the preceding claims, **characterised in that** the substrate (1) is coated with an optical coating (23) which comprises an interference layer.

19. Method as claimed in any one of the preceding claims, **characterised in that** the substrate (1) is coated with an optical coating (23) which comprises a colour or absorption layer.

20. Method as claimed in any one of the preceding claims, **characterised in that** a light bulb (100) is coated.

21. Use of a device for coating curved and/or multi-surface substrates (1) for the method in accordance with any one of the preceding claims, wherein the device comprises a computer-controlled print head (7) with a storage container (11) filled with lacquer (13) for coating a surface (3) of a curved and/or multi-surface substrate (1) with lacquer (13), and a device for computer-controlled tracking of the distance from the at least one nozzle (9) of the print head (7) to the curved and/or multi-surface substrate surface (3).

## Revendications

1. Procédé de fabrication d'un substrat (1) avec un revêtement optique à dessins sur une surface convexe (3), dans lequel
- on applique sur la surface convexe (3) un masquage qui couvre une zone partielle de la surface convexe (3),
- on applique un revêtement optique (23) avec un procédé de dépôt sous vide, et
- on élimine le masquage,
**caractérisé en ce que** l'on applique comme masquage une couche de vernis (5) au moyen d'une tête d'impression commandée par ordinateur, la distance entre la tête d'impression et la surface convexe étant adaptée ou suivie pendant l'application de la couche de vernis (5).

2. Procédé selon la revendication 1, **caractérisé en ce que** l'application du revêtement optique (23) comprend le dépôt d'une couche au moyen d'un dépôt physique en phase vapeur (PVD).

3. Procédé selon la revendication 1 ou 2, **caractérisé en ce que** l'application du revêtement optique (23) comprend l'application d'une couche par vaporisation.

4. Procédé selon l'une des revendications précédentes, **caractérisé en ce que** l'application du revêtement optique (23) comprend la pulvérisation d'une couche.

5. Procédé selon l'une des revendications précédentes, **caractérisé en ce que** l'application du revêtement optique (23) comprend l'application d'une couche au moyen d'un dépôt chimique en phase vapeur (CVD).

6. Procédé selon la revendication 5, **caractérisé en ce que** le revêtement s'effectue au moyen d'un dépôt chimique en phase vapeur par impulsions de plasma (PICVD).

7. Procédé selon l'une des revendications précédentes, **caractérisé en ce que** l'on refroidit le vernis (13).

8. Procédé selon la revendication 7, **caractérisé en ce que** l'on refroidit le vernis (13) dans un réservoir de stockage (11) relié à la buse (9) ou à travers une conduite d'alimentation ou à travers la buse (9).

9. Procédé selon l'une des revendications précédentes, **caractérisé en ce que** l'on applique le vernis (13) dans une atmosphère contenant un solvant ou comprimée.

10. Procédé selon l'une des revendications précédentes, **caractérisé en ce que** l'on applique le vernis (13) sur un substrat chauffé (1).

11. Procédé selon l'une des revendications précédentes, **caractérisé en ce que** le masquage du substrat (1) comprend l'application d'un vernis à décalquer.

12. Procédé selon l'une des revendications précédentes, **caractérisé en ce que** le masquage du substrat (1) comprend l'agencement d'un masque mécanique (39).

13. Procédé selon l'une des revendications précédentes, **caractérisé en ce que** le masquage du substrat comprend l'application d'un premier masquage (5) et d'un deuxième masquage (6) se chevauchant avec le premier masquage.

14. Procédé selon l'une des revendications précédentes, **caractérisé en ce que** l'élimination du masquage comprend la dissolution ou la corrosion d'un masquage au vernis (5).

15. Procédé selon l'une des revendications précédentes, **caractérisé en ce que** l'on applique un revêtement optique (23) à plusieurs couches.

16. Procédé selon l'une des revendications précédentes, **caractérisé en ce que** l'on revêt le substrat (1) avec une couche optique qui comprend une couche de réflexion partiellement ou totalement réfléchissante.

17. Procédé selon la revendication 16, **caractérisé en ce que** l'on applique un revêtement optique à réflexion colorée.

18. Procédé selon l'une des revendications précédentes, **caractérisé en ce que** l'on revêt le substrat (1) avec un revêtement optique (23) qui comprend une couche d'interférence.

19. Procédé selon l'une des revendications précédentes, **caractérisé en ce que** l'on revêt le substrat (1) avec un revêtement optique (23) qui comprend une couche de couleur ou d'absorption.

20. Procédé selon l'une des revendications précédentes, **caractérisé en ce que** l'on revêt une ampoule de lampe (100).

21. Utilisation d'un dispositif pour le revêtement de substrats (1) convexes et/ou à plusieurs surfaces pour le procédé selon l'une des revendications précédentes, le dispositif comprenant une tête d'impression (7) commandée par ordinateur avec un réservoir de stockage (11) rempli de vernis (13) pour le revêtement d'une surface (3) d'un substrat (1) convexe et/ou à plusieurs surfaces avec du vernis (13) ainsi qu'un dispositif pour l'adaptation commandée par ordinateur de la distance entre l'au moins une buse (9) de la tête d'impression (7) et la surface de substrat (3) convexe et/ou à plusieurs surfaces.
